# EUROPEAN PATENT APPLICATION

(11) **EP 1 850 648 A1**
(43) Date of publication of application: **31.10.2007**
(21) Application number: 06822717.2
(22) Date of filing: 31.10.2006
(51) Int. Cl.: H05K 3/46

(54) **MULTILAYER PRINTED WIRING BOARD FOR SEMICONDUCTOR DEVICE AND PROCESS FOR PRODUCING THE SAME**

(30) Priority: 02.11.2005 JP 2005319432
(71) Applicant: IBIDEN CO., LTD., Ogaki-shi Gifu 503-8604 (JP)
(72) Inventor: NIKI, Ayao, Ogaki-shi Gifu 503-8604 (JP)
(74) Representative: Grünecker, Kinkeldey, Stockmair & Schwanhäusser Anwaltssozietät
(86) International application number: PCT/JP2006/321788
(87) International publication number: WO 2007/052674

(57) **Abstract**

A multilayer printed wiring board includes one or more resin layers having via-holes and a core layer having via-holes. The via-holes formed in the one or more resin layers are open in the direction opposite to the direction in which the via-holes formed in the core layer are open. A method for manufacturing a multilayer printed wiring board includes a step of preparing a single- or double-sided copper-clad laminate; a step of forming lands by processing the laminate; a step of forming a resin layer on the upper face of the laminate, forming openings for via-holes in the resin layer, and then forming the via-holes; and a step of forming openings for via-holes in the lower face of the laminate and then forming the via-holes.

## Description

### BACKGROUND OF THE INVENTION

### Field of the Invention

The present invention relates to multilayer printed wiring boards for semiconductor devices and methods for manufacturing such boards. The present invention specifically relates to a multilayer printed wiring board, having a small thickness, for semiconductor devices and a method for manufacturing such a board.

### Description of the Related Art

Japanese Laid-Open Publication No. 2000-323613 (Date of Laid-Open: Nov. 24, 2000) (corresponding to US Patent Application Publication No. US 2002/0195272 A1; Pub. Date Dec. 26, 2002) discloses a multilayer printed wiring board, having a small thickness, for semiconductor devices, wherein the multilayer printed wiring board is manufactured in such a manner that a copper plate serving as a support is prepared, a semiconductor device-mounting layer having a face for mounting semiconductor devices and an externally connecting layer having a face for an external connection are formed on the copper plate; via-holes, conductive wires, and an insulating layer are formed in that order in the direction from the semiconductor device-mounting layer to the externally connecting layer; and the copper plate is then removed.

The multilayer printed wiring board needs to be connected to a semiconductor element (for example, an IC chip) at many points in some cases because the semiconductor element has a large number of gates. A large number of pads provided in the semiconductor element are connected to lands provided in the printed wiring board at, for example, 2,000 to 30,000 connection points.

Such semiconductor element is mounted on the printed wiring board, then the printed wiring board is usually tested with a plug-in tester or the like. The test happens to show that some of the connection points are faulty. Hence, it has been desired to develop a multilayer printed wiring board, that is connected to a semiconductor element at many connection points, with the capability of suppressing the occurrence of misconnections.

After a printed wiring board is subjected to a temperature cycle test (also referred to as "heat cycle test") in such a manner that this printed wiring board is alternately exposed to a cold atmosphere (for example, -55°C) and a hot atmosphere (for example, 125°C) several times, cracks can be seen at times in this printed wiring board. The creation of the cracks in the temperature cycle test leads to a deterioration in the long-term reliability of this printed wiring board and is therefore not preferable. Hence, it has been also desired to develop a multilayer printed wiring board that can reduced the occurrence of cracks during an acceleration test.

### SUMMARY OF THE INVENTION

Accordingly, it is an object of the present invention to provide a multilayer printed wiring board securely connectable to a semiconductor element at many connection points.

It is another object of the present invention to provide a method for manufacturing such a multilayer printed wiring board.

It is another object of the present invention to provide a multilayer printed wiring board that can reduced the occurrence of cracks during an acceleration test.

It is another object of the present invention to provide a method for manufacturing this multilayer printed wiring board.

In consideration of the above objects, a multilayer printed wiring board according to the present invention comprises: one or more resin layers having via-holes; and a core layer having via-holes, wherein the via-holes of the one or more resin layers are open in the direction opposite to the direction in which the via-holes of the core layer are open.

Further, in the multilayer printed wiring board, the multilayer printed wiring board may have a surface for mounting a semiconductor element and a surface on which an external terminal is formed, the via-holes formed in the one or more resin layers may be open in the face for mounting a semiconductor element, and the via-holes formed in the core layer may be open in the face on which an external terminals is formed.

Further, a multilayer printed wiring board according to the present invention comprises: a first resin layer; first via-holes formed in the first resin layer; a second resin layer disposed on the upper face of the first resin layer; second via-holes formed in the second resin layer; a core layer disposed on the lower face of the first resin layer; and via-holes formed in the core layer; wherein the via-holes formed in the first and second resin layers are open in the direction opposite to the direction in which the via-holes formed in the core layer are open.

Further, in the multilayer printed wiring board, the via-holes may be filled with a conductor.

Further, in the multilayer printed wiring board, the via-holes formed in the one or more resin layers may broaden upward and may taper downward and the via-holes formed in the core layer may taper upward and may broaden downward.

Further, in the multilayer printed wiring board, the multilayer printed wiring board may further comprise one or more resin layers, disposed on the upper surface of the second resin layer, having via-holes.

Further, in the multilayer printed wiring board, the core layer may be made of fiber-reinforced plastic.

Further, in the multilayer printed wiring board, the core layer may include a substrate prepared by impregnating a woven glass fabric or a nonwoven aramid fabric with an epoxy resin or a bismaleimide-triazine resin and then subjecting the resulting resin to curing.

Further, in the multilayer printed wiring board, the glass fabric may have a two-ply construction.

Further, in the multilayer printed wiring board, the core layer may be prepared from a single- or double-sided copper-clad laminate and may have lands prepared of a copper foil attached to the laminate.

Further, a method for manufacturing a multilayer printed wiring board according to the present invention comprises the steps of: preparing a single- or double-sided copper-clad laminate; forming lands by processing the laminate; forming a resin layer on the upper face of the laminate, forming openings for via-holes in the resin layer, and then forming the via-holes; and forming openings for via-holes in the lower face of the laminate and then forming the via-holes, wherein the via-holes formed in the resin layer are open in the direction opposite to the direction in which the via-holes formed in the laminate are open.

Further, in the method for manufacturing a multilayer printed wiring board, the via-holes formed in the resin layer may broaden upward and may taper downward in cross section and the via-holes formed in the laminate may taper upward and may broaden downward in cross section.

Further, in the method for manufacturing a multilayer printed wiring board, the laminate may include a glass fabric impregnated with an epoxy resin.

Further, in the method for manufacturing a multilayer printed wiring board, the method further comprises: one or more steps of forming another resin layer, forming openings for via-holes, and then forming the via-holes, the one or more steps being subsequent to the step of forming the resin layer on the upper face of the laminate, forming the openings in the resin layer, and then forming the via-holes.

Further, in the method for manufacturing a multilayer printed wiring board, the via-holes may be filled with a conductor by plating process.

Further, in the method for manufacturing a multilayer printed wiring board, the openings may be formed with a laser.

Further, in the method for manufacturing a multilayer printed wiring board, two single- or double-sided copper-clad laminates included glass-based materials impregnated with an epoxy resin may be prepared and then attached to each other with an adhesive in the laminate-preparing step; the attached laminates may be processed together in the land-forming step and the step of forming the resin layer on the upper face of the laminate, forming the openings in the resin layer, and then forming the via-holes; the processed laminates may be separated from each other by melting or softening the adhesive; and the separated laminates may be separately subjected to the step of forming the openings in the lower face of the laminate and then forming the via-holes.

Further, a multilayer printed wiring board according to the present invention comprises: a first resin layer; via-holes formed in the first resin layer; a second resin layer disposed on the upper face of the first resin layer; via-holes formed in the second resin layer; a third resin layer disposed on the lower face of the first resin layer; and via-holes formed in the third resin layer; wherein the via-holes formed in the first and second resin layers are open in the direction opposite to the direction in which the via-holes formed in the third resin layer are open.

Further, in the multilayer printed wiring board, the via-holes formed in the first and second resin layers may broaden upward and may taper downward and the via-holes formed in the third resin layer taper upward and broaden downward.

Further, in the multilayer printed wiring board, the multilayer printed wiring board may further comprise one or more resin layers similar to the first or second resin layer.

Further, a method for manufacturing a multilayer printed wiring board according to the present invention comprises: a step of preparing a support plate; a step of forming lands on the support plate; a step of forming a first resin layer on the upper face of the support plate, forming openings for via-holes in the first resin layer, and then forming the via-holes; a step of forming a second resin layer on the upper face of the first resin layer, forming openings for via-holes in the second resin layer, and then forming the via-holes; a step of removing the support plate; and a step of forming a third resin layer on the lower face of the first resin layer, forming openings for via-holes in the third resin layer, and then forming the via-holes; wherein the via-holes formed in the first and second resin layers are open in the direction in which the via-holes formed in the third resin layer are open.

Further, in the method for manufacturing a multilayer printed wiring board, the support plate may be made of copper.

Further, in the method for manufacturing a multilayer printed wiring board, the via-holes formed in the first and second resin layers may broaden upward and may taper downward and the via-holes formed in the third resin layer taper may upward and may broaden downward.

Further, in the method for manufacturing a multilayer printed wiring board, the method may further comprise two or more steps of forming another resin layer, forming openings for via-holes, and then forming the via-holes.

Further, in the method for manufacturing a multilayer printed wiring board, the via-holes may be filled with a conductor by plating process.

Further, in the method for manufacturing a multilayer printed wiring board, the openings may be formed with a laser.

Further, in the method for manufacturing a multilayer printed wiring board, two support plates may be prepared and then attached to each other with an adhesive in the laminate-preparing step; the attached support plates may be processed together in the land-forming step and the second resin layer-forming step; the processed support plates may be separated from each other by melting or softening the adhesive; and the separated support plates may be separately subjected to the support plate-removing step.

### BRIEF DESCRIPTION OF THE DRAWINGS

Fig. 1 is a sectional view of a multilayer printed wiring board according to a first embodiment of the present invention;
Figs. 2A to 2R are illustrations showing steps of manufacturing the multilayer printed wiring board shown in Fig. 1;
Fig. 3 is a sectional view of a multilayer printed wiring board according to a second embodiment of the present invention;
Figs. 4A to 4T are illustrations showing steps of manufacturing the multilayer printed wiring board shown in Fig. 3; and
Fig. 5 is a sectional view of a multilayer printed wiring board according to a third embodiment of the present invention.

### (Explanation of Reference Numeral)

10:multilayer printed wiring board, 11,12:each layer, 13:solder bump, 14,14-1,14-2:land, 15:land, 20:multilayer printed wiring board of the first embodiment, 21:glass cloth base epoxy-resin impregnated copper-clad laminate, 22:lowermost layer, core layer, laminate, 22a:opening, 23:copper foil, 25:land, 26-1,26-2:resin layer, 27:protrusions, anchors, 28-1,28-2:electroless plating layer, 29-1,29-2:electro plating layer, 30: multilayer printed wiring board of the second embodiment, 32-1,32-2:via hole, 33-1,33-2:etching resist, 42:via hole, 52:resin layer, 60:support plate, copper plate, 220:insulating layer,

### DESCRIPTION OF THE PREFERRED EMBODIMENTS

Embodiments of the present invention will now be described in detail with reference to the accompanying drawings. In order to avoid repetition, the same components shown in the accompanying drawings shall have the same reference numerals.

### [First Embodiment]

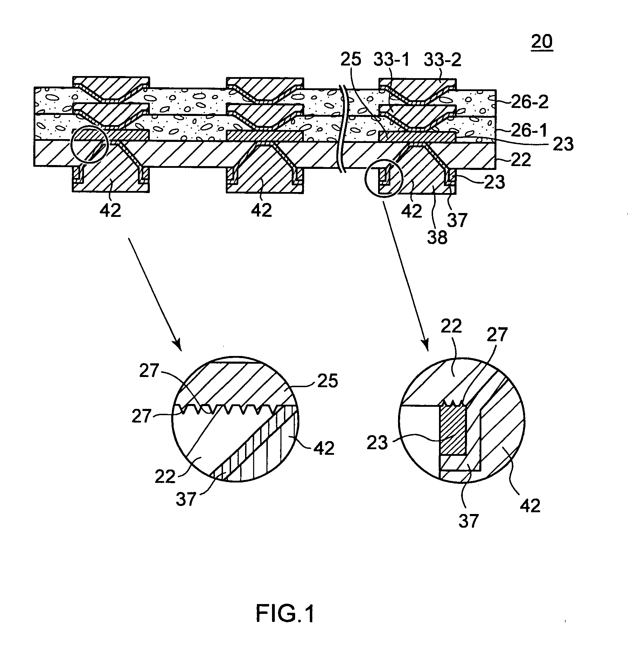

Fig. 1 shows a multilayer printed wiring board 20 according to a first embodiment of the present invention. The multilayer printed wiring board 20 includes a first resin layer 26-1, first via-holes 33-1 formed in the first resin layer 26-1, a second resin layer 26-2 disposed on the upper face of the first resin layer 26-1, second via-holes 33-2 formed in the second resin layer 26-2, a core layer 22 disposed on the lower face of the first resin layer 26-1, and third via-holes 42 formed in the core layer 22. The first and second via-holes 33-1 and 33-2 are open in the direction opposite to the direction in which the third via-holes 42 are open.

The first and second via-holes 33-1 and 33-2 may broaden upward and may taper downward. In contrast, the third via-holes 42 may taper upward and may broaden downward.

The core layer 22, which is located lowermost, is preferably made of fiber-reinforced plastics (FRP). The core layer 22 is more preferably prepared from a copper-clad laminate such as a glass cloth base epoxy resin impregnated double-sided copper clad laminate.

The multilayer printed wiring board 20 includes the first and second resin layers 26-1 and 26-2 as shown in Fig. 1. The multilayer printed wiring board 20 is not limited to such a configuration and may include one or three or more resin layers disposed on the upper face of the core layer 22.

The multilayer printed wiring board 20 has advantages below.
(1) Since the first and second via-holes 33-1 and 33-2 are open in the direction opposite to the direction in which the third via-holes 42 are open, the first and second resin layers 26-1 and 26-2 are warped in the direction opposite to the direction in which the core layer 22 are warped; hence, the multilayer printed wiring board 20 is hardly warped.
   Since the multilayer printed wiring board 20 is hardly warped by heating during the reflow of solder bumps, the distance between the multilayer printed wiring board 20 and each semiconductor element is maintained substantially constant. Therefore, even if the multilayer printed wiring board 20 has a semiconductor element-mounting region (that is, a region having pads connected to electrodes of the semiconductor elements) having a large area of 200 to 2,000 mm² and the number of the pads is 2,000 to 30,000, problems such as misconnections hardly occur.
(2) Since the core layer 22 typically includes the glass-based material, the core layer 22 has a smaller thermal expansion coefficient and a higher dimensional stability as compared to a layer made of only resin, for example, an epoxy resin. If semiconductor elements (not shown) are mounted on the second resin layer 26-2, the semiconductor elements, the first resin layer 26-1, the second resin layer 26-2, and the core layer 22 are arranged in that order. That is, the first and second resin layers 26-1 and 26-2 are sandwiched between the core layer 22 and the semiconductor elements having a thermal expansion coefficient less than those of the first and second resin layers 26-1 and 26-2. Therefore, the multilayer printed wiring board 20 can reduce the occurrence of cracks during a temperature cycle test because the multilayer printed wiring board 20 is hardly warped.
(3) The core layer 22 is preferably prepared from the copper-clad laminate and uses the copper foils 23 as described above. For example, the core layer 22 is typically of a glass-cloth base epoxy-resin impregnated copper-clad laminate. When a copper-clad laminate is in general manufactured by a laminate maker, a face of each copper foil 23 facing to a laminate 22 is usually matte-finished (roughened) such that the copper foil 23 is securely fixed to the laminate 22. The microscopic observation of the copper foil 23 shows that the copper foil 23 has protrusions (anchors) 27 extending into the laminate 22 as shown in the circles in Fig. 1. This allows the copper foil 23 to be tightly fixed to the laminate 22.
   That is, the adhesion between the copper foil 23 and the laminate 22 is very strong. Hence, the multilayer printed wiring board 20 is tough.
(4) The core layer 22 is preferably prepared from a glass cloth base epoxy-resin impregnated copper-clad laminate. The glass cloth base includes a plurality of sheets of woven glass fabric (not shown) with high dimensional stability against heat. Since the multilayer printed wiring board 20 has the sheets of woven glass fabric, therefore it has high stiffness and is hardly warped.

### (Method for manufacturing)

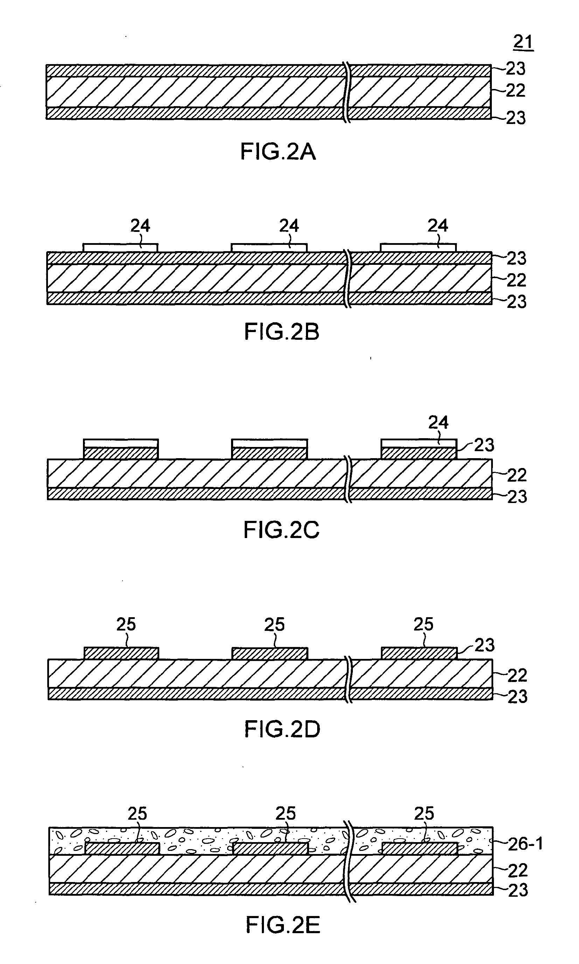

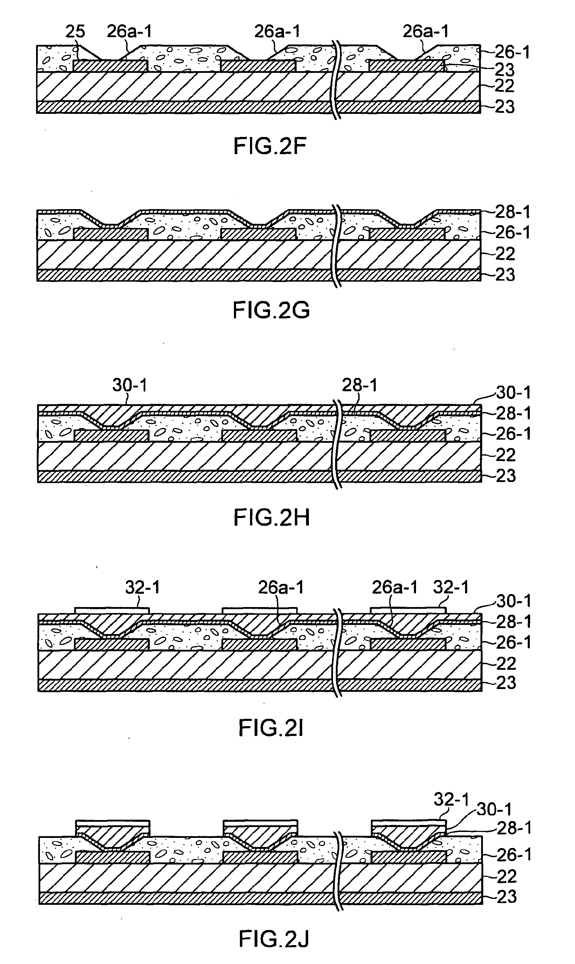

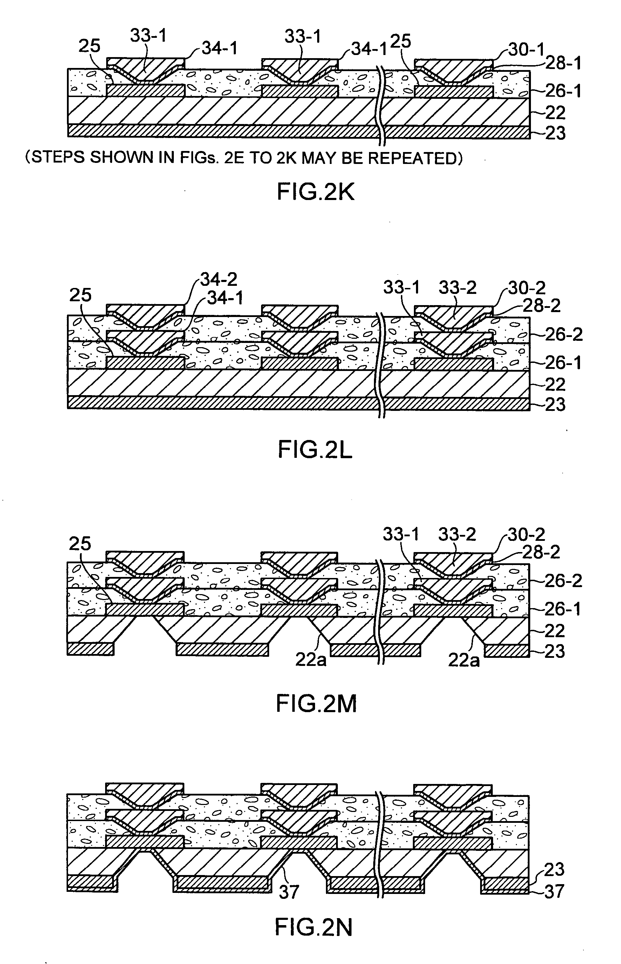

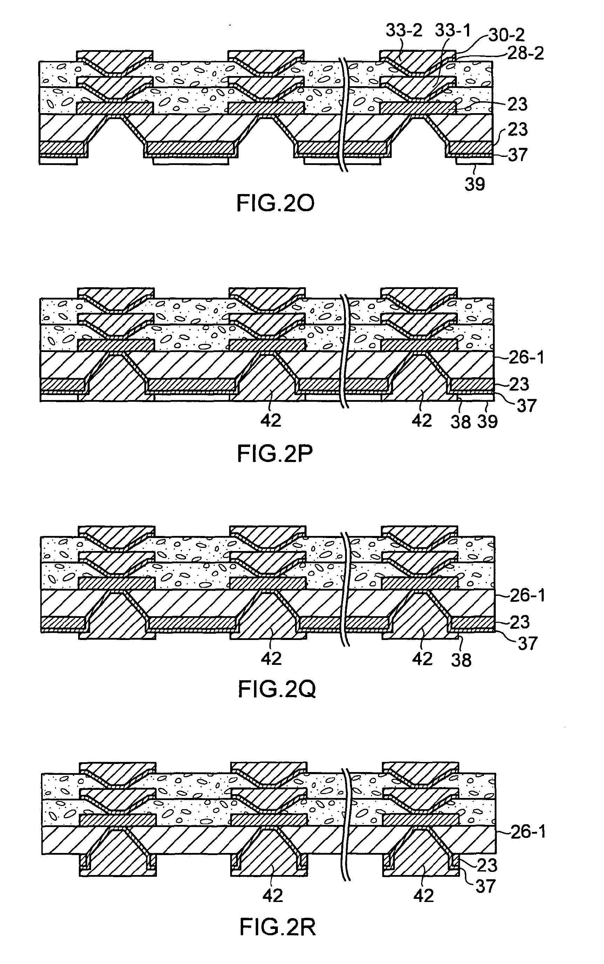

A method for manufacturing the multilayer printed wiring board 20 will now be described with reference to Figs. 2A to 2R.

As shown in Fig. 2A, a double-sided copper-clad laminate (for example, NEMA grade FR-4) 21 is prepared as starting material. The laminate 22 for a core base is preferably formed in such a manner that a plurality of sheets (not shown) of woven glass fabric impregnated with a thermosetting epoxy resin is semi-cured. The copper-clad laminate 21 is then formed by cladding copper foils to both faces of the laminate 22, respectively, and then these are heat-cured. For example, a glass cloth base epoxy-resin impregnated copper-clad laminate with a thickness of about 0.06 mm, including the copper foils 23 each having a thickness of about 12 µm may be used.

Alternatively, the following laminates may be used to manufacture the core layer 22: a laminate including a glass-based material impregnated with a bismaleimide triazine resin, a laminate including a glass-based material impregnated with a polyphenylene ether resin, or a laminate including a glass-based material impregnated with a polyimide resin. The core layer 22 preferably has a thickness of 0.04 to 0.40 mm. This is because the warpage of the multilayer printed wiring board 20 can be reduced due to the stiffness of the core layer 22 and the counter balance between the warpage of the core layer 22 and that of the first and second resin layers 26-1 and 26-2.

As shown in Fig. 2B, first etching resist layers 24 are provided on regions of the upper one of the copper foils 23, the regions being used to subsequently form patterns for portions, land portions, conductive circuits and the like (hereinafter simply referred to as "lands"). The first etching resist layers 24 can be formed in such a manner that, for example, a dry film is laminated on the upper copper foil 23 and then partly removed to form the lands by photolithography. Alternatively, the first etching resist layers 24 may be formed by screen printing using a liquid resist.

As shown in Fig. 2C, portions of the upper copper foil 23 that are exposed from the first etching resist layers 24 are removed by etching.

As shown in Fig. 2D, the first etching resist layers 24, disposed on the remaining portions of the upper copper foil 23, are removed, whereby first lands 25 made of the upper copper foil 23 are exposed.

As shown in Fig. 2E, the first resin layer 26-1 is provided on the core layer 22. The first resin layer 26-1 can be formed in such a manner that an interlayer insulating resin film (for example, a film, grade ABF, available from Ajinomoto Fine-Techno. Co. Inc), a semi-cured resin sheet such as a prepreg and the like is attached to the core layer 22 and then heat-cured, or in such a manner that pre-cured resin is applied to the core layer 22 by screen printing and then heat-cured. Before the first resin layer 26-1 is formed, the surfaces (including side faces) of the first lands 25 may be roughened.

As shown in Fig. 2F, first openings 26a-1 for forming the first via-holes 33-1 are formed in the first resin layer 26-1 by laser irradiation using, for example, a carbon dioxide laser such that the first openings 26a-1 are located above the respective first lands 25. Since the first lands 25 function as stoppers during the formation of the first openings 26a-1 by laser irradiation, the first openings 26a-1 extend up to the upper faces of the first lands 25. That is, the first via-holes 33-1 extend from the upper face of the first resin layer 26-1 to the upper face of the first lands 25. The first openings 26a-1 may broaden upward and may taper downward, that is, the first openings 26a-1 may have a downward tapered shape. Therefore, the first via-holes 33-1 may be, not rectangular, substantially trapezoidal in cross section. That is, the entire first via-holes 33-1 do not have a cylindrical shape, but substantially a an inversed frusto-conical shape.

An excimer laser, a YAG laser, or a UV laser may be used instead of the carbon dioxide laser. A protective film such as a PET film may be used during the formation of the first openings 26a-1 as required. This can be applied to the formation of openings below.

As shown in Fig. 2G, catalyst seeds for electroless plating are provided on the first resin layer 26-1 having the first openings 26a-1 by, for example, sputtering and a first copper layer 28-1 with a thickness of 0.6 to 3.0 µm is then formed on the first resin layer 26-1 by electroless plating. Before the first copper layer 28-1 is formed, the first resin layer 26-1 may be processed desmear as required such that resin residues are removed therefrom.

As shown in Fig. 2H, a second copper layer 30-1 with a thickness of, for example, several ten micrometers is formed on the first copper layer 28-1 by electroplating using the first copper layer 28-1 as a feeder, that is, an electrode. Alternatively, the second copper layer 30-1 may be formed by electrolytic solder plating. Alternatively, the first copper layer 28-1 and the second copper layer 30-1 may be entirely formed by electroless copper plating, then the second copper layer 30-1 may be flattened by an appropriate process as required.

As shown in Fig. 21, second etching resist layers 32-1 are provided on the second copper layer 30-1 such that the second etching resist layers 32-1 are located above the respective first openings 26a-1. For example, the second etching resist layers 32-1 can be formed by photolithography or screen printing as described above with reference to Fig. 2B.

As shown in Fig. 2J, regions of the first and second copper layers 28-1 and 30-1 that are exposed from the second etching resist layers 32-1 are removed by etching.

As shown in Fig. 2K, the second etching resist layers 32-1 on the remaining regions of the second copper layer 30-1 are removed, whereby second lands 34-1 made of the first and second copper layers 28-1 and 30-1 are exposed on the first resin layer 26-1. The second lands 34-1 are formed by a subtractive process as described above and may be formed by a known semi-additive process. In order to simplify Fig. 2K, individual conductive circuits are not shown. In this step, the first via-holes 33-1 filled with copper are formed such that the first lands 25 are electrically connected to the respective second lands 34-1. The first via-holes 33-1 may have a cross-sectional shape corresponding to that of the first openings 26a-1 described with reference to Fig. 2F, thus it may have a downward tapered shape, therefore the entire first via-holes 33-1 do have substantially an inversed frusto-conical shape.

At the point of time when this step is finished, the first resin layer 26-1 disposed on the core layer 22 has the second lands 34-1 and the first via-holes 33-1. The surface configuration of the first resin layer 26-1 having the second lands 34-1 is substantially the same as that of the core layer 22 having the first lands 25 shown in Fig. 2D. Therefore, a desired number of resin layers may be formed on the first resin layer 26-1 by repeating the steps shown in Figs. 2E to 2K. In this embodiment, these steps are repeated one more time.

As shown in Fig. 2L, the second resin layer 26-2 is formed on the first resin layer 26-1 by repeating the steps shown in Figs. 2E to 2K once.

As shown in Fig. 2M, second openings 22a for forming via-holes are formed in the core layer 22 in such a manner that the lower one of the copper foils 23 is partly removed by photolithography and regions of the lower face of the core layer 22 are then irradiated with a laser beam, the regions being located below the respective first lands 25. This process is so-called a conformal process. In this step, the first lands 25 function as stoppers, hence, the second openings 22a extend up to the lower faces of the first lands 25. Therefore, the second openings 22a are open in the direction opposite to the direction in which the first openings 26a-1 in the first resin layer 26-1 and openings 25a-2 in the second resin layer 26-2 are open. The second openings 22a may broaden downward and may taper upward, that is, the second openings 22a may have an upward tapered shape.

As shown in Fig. 2N, a third copper layer 37 is formed over the remaining regions of the lower copper foil 23 and the core layer 22 having the second openings 22a by electroless copper plating. Before the third copper layer 37 is formed, catalyst seeds for electroless plating may be provided on the core layer 22 by, for example, sputtering or plating as required.

As shown in Fig. 20, plating resist layers 39 are provided on the third copper layer 37 so as not to cover the second openings 22a and conductive circuits (not shown). The plating resist layers 39 can be formed by photolithography or screen printing as described above with reference to Fig. 2B.

As shown in Fig. 2P, a fourth copper layer 38 is formed on the third copper layer 37 by electroplating using the third copper layer 37 as a feeder, whereby the third via-holes 42 are formed. The third via-holes 42 is open in the direction opposite to the direction in which the first and second via-holes 33-1 and 33-2 shown in Figs. 2K and 2L are open. The third via-holes 42 may taper upward and may broaden downward. The third and fourth copper layers 37 and 38 may be entirely formed by electroless copper plating.

As shown in Fig. 2Q, the plating resist layers 39 disposed on the third copper layer 37 are removed.

As shown in Fig. 2R, after appropriate etching resist layers are formed on the third via-holes 42, the third copper layer 37 and the remaining regions of the lower copper foil 23 are partly removed by etching. These etching resist layers are then removed. Regions other than sections for soldering lands disposed on one or both faces of the multilayer printed wiring board 20 may be covered with a solder resist (not shown) such that the formation of solder bridges is prevented. According to the above procedure, the multilayer printed wiring board 20 shown in Fig. 1 can be manufactured.

### [Second Embodiment]

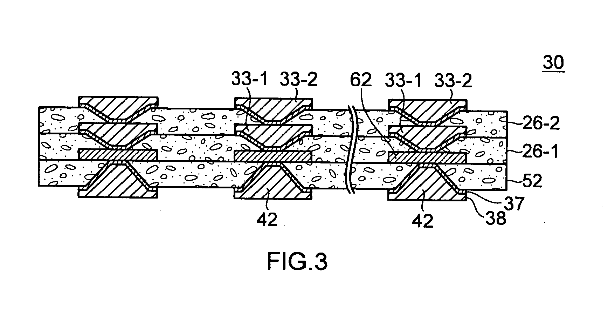

Fig. 3 shows a multilayer printed wiring board 30 according to a second embodiment of the present invention. The multilayer printed wiring board 30 of this embodiment is different from the multilayer printed wiring board 20 of the first embodiment in that the multilayer printed wiring board 30 of this embodiment is coreless. That is, the multilayer printed wiring board 30 of this embodiment includes a third resin layer 52 which is located lowermost and which is different from the core layer 22 in that the third resin layer 52 includes no core material such as a glass cloth. The multilayer printed wiring board 30 of this embodiment further may include first via-holes 33-1 and second via-holes 33-2 similar to those included in the multilayer printed wiring board 20 of the first embodiment. Thus, the multilayer printed wiring board 30 of this embodiment has substantially the same advantages as those of the multilayer printed wiring board 20 of the first embodiment.

The third resin layer 52 has substantially the same configuration as those of a first resin layer 26-1 and second resin layer 26-2 included in the multilayer printed wiring board 30 of this embodiment. Although the multilayer printed wiring board 30 of this embodiment is inferior in dimensional stability, it is superior in flexibility to the multilayer printed wiring board 20 of the first embodiment. Hence, the multilayer printed wiring board 30 of this embodiment can readily absorb the expansion or shrinkage of a wiring board during solder reflow.

The multilayer printed wiring board 30 of this embodiment has advantages below.
(1) The multilayer printed wiring board 30 is hardly warped by heat during solder reflow; hence, a problem such as a faulty connection between a semiconductor device and a printed board hardly occurs.
(2) Since the multilayer printed wiring board 30 is flexible and readily absorbs the expansion of such a wiring board during solder reflow. Therefore, the multilayer printed wiring board 30 absorbs a difference in thermal expansion coefficient between a semiconductor element and a printed board 10, hence, cracks due to such a difference are hardly formed.

With reference to Fig. 3, the multilayer printed wiring board 30 includes the first and second resin layers 26-1 and 26-2 arranged on a support plate (a copper plate) as described above. The present invention is not limited to this configuration. The multilayer printed wiring board 30 may include three or more resin layers as required.

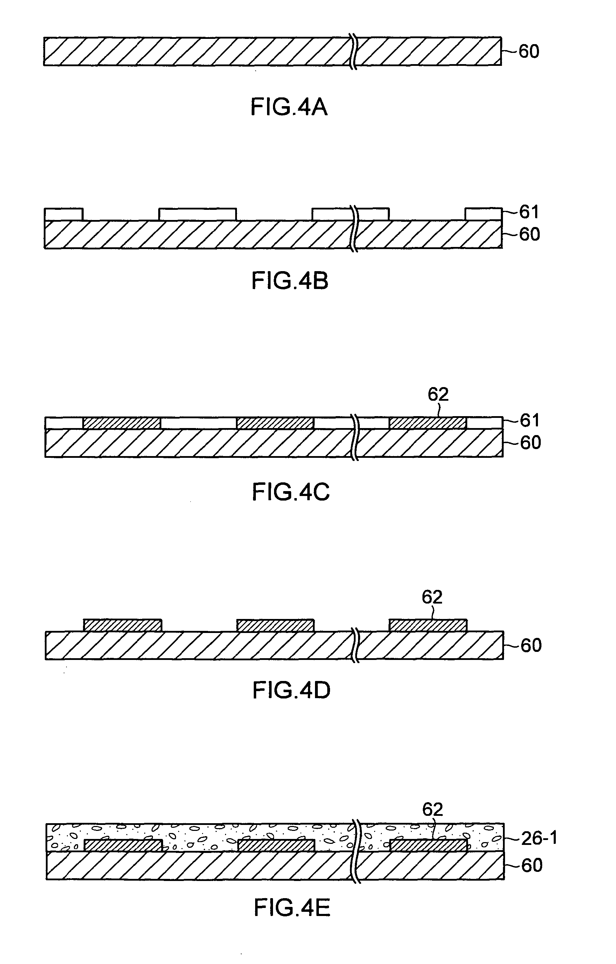

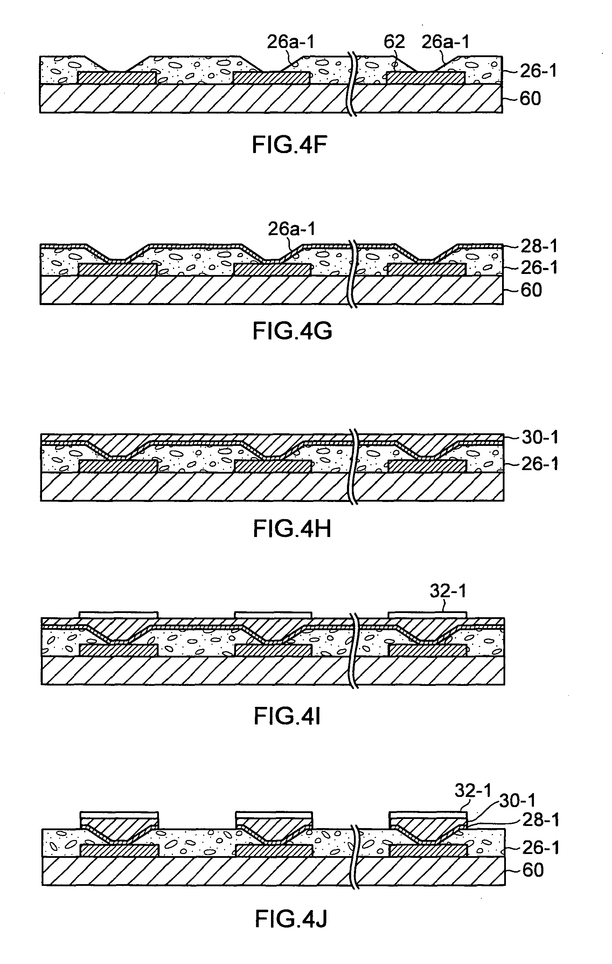

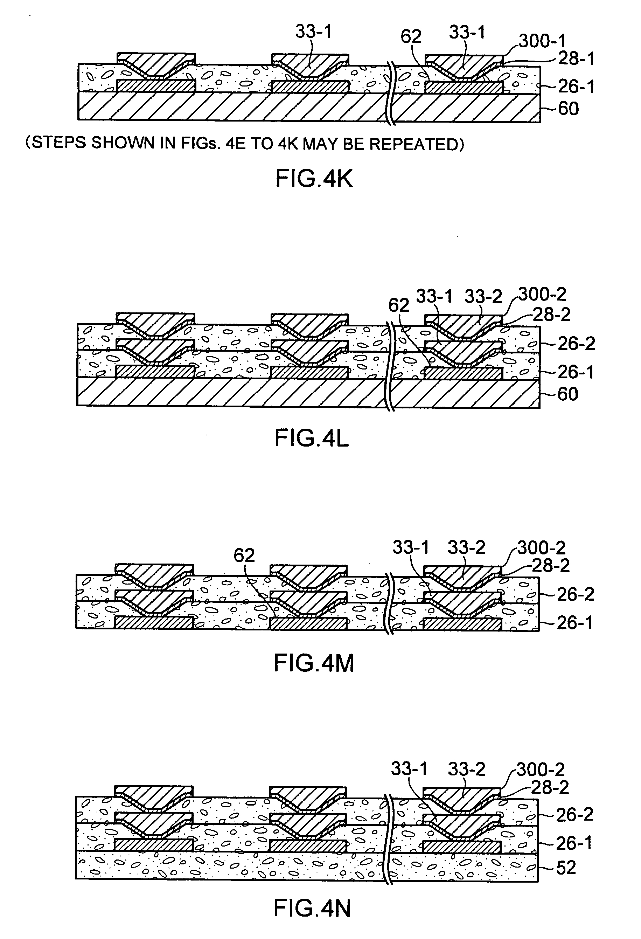

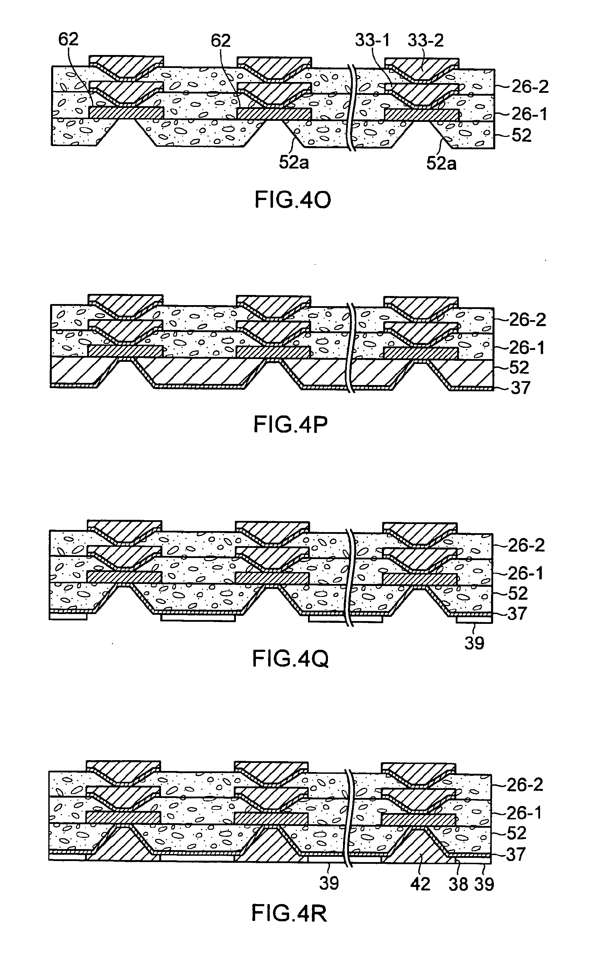

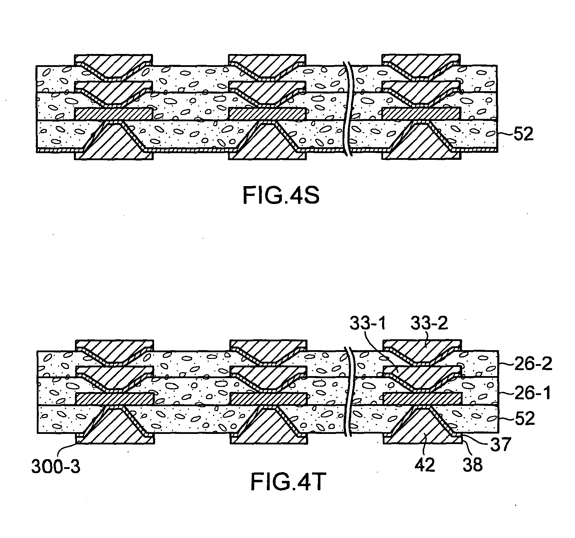

A method for manufacturing the multilayer printed wiring board 30 shown in Fig. 3 will now be described with reference to Figs. 4A to 4T. If some of steps shown in Figs. 4A to 4T are substantially identical to those shown in Figs. 2A to 2R, the facts will be described and the descriptions of the identical steps will be omitted.

As shown in Fig. 4A, a support plate 60 is prepared as starting material. The support plate 60 is preferably made of copper.

As shown in Fig. 4B, plating resist layers 61 are provided on the upper face of the support plate 60. The plating resist layers 61 can be formed in such a manner that, for example, a dry film is laminated on the support plate 60 and then patterned by photolithography. Alternatively a liquid resist may be applied onto the support plate 60 by screen printing to form the plating resist layers 61.

As shown in Fig. 4C, copper layers 62 are formed on regions of the support plate 60 other than the plating resist layers 61 by electrolytic plating using the support plate 60 as a feeder. Before the copper layers 62 are formed, seed layers (not shown) including, for example, chromium sublayers and copper sublayers may be formed by plating so as to serve as bases for the copper layers 62. The chromium sublayers are not etched off by an etchant used to etch the support plate 60 in a step shown in Fig. 4M and therefore function as etching stoppers.

As shown in Fig. 4D, the plating resist layers 61 disposed on the upper face of the support plate 60 are removed, whereby the copper layers 62 used to form patterns for lands and/or conductive circuits are allowed to remain on the support plate 60.

A step of forming a first resin layer 26-1 on the support plate 60 as shown in Fig. 4E is substantially identical to the step shown in Fig. 2E. An opening-forming step performed as shown in Fig. 4F is substantially identical to the step shown in Fig. 2F. An electroless plating step performed as shown in Fig. 4G is substantially identical to the step shown in Fig. 2G. An electrolytic plating step performed as shown in Fig. 4H is substantially identical to the step shown in Fig. 2H. An etching resist-forming step performed as shown in Fig. 4I is substantially identical to the step shown in Fig. 2I. An etching step performed as shown in Fig. 4J is substantially identical to the step shown in Fig. 2J. An etching resist-removing step performed as shown in Fig. 4K is substantially identical to the step shown in Fig. 2K.

In the stage in Fig. 4K, the first resin layer 26-1 having lands 30-1 and first via-holes 33-1 is disposed on the support plate 60. The surface configuration of the first resin layer 26-1 having land 30-1 is substantially the same as that of the support plate 60 having the copper layers 62 shown in Fig. 4D. A necessary number of resin layers can be formed on the first resin layer 26-1 by repeating the steps shown in Figs. 4E to 4K necessary times. In this embodiment, these steps are repeated one more time.

As shown in Fig. 4L, a second resin layer 26-2 having second via-holes 33-2 is formed on the first resin layer 26-1 by repeating the steps shown in Figs. 4E to 4K once.

As shown in Fig. 4M, the support plate 60 is removed by etching. In the step, the seed layers described above with reference to Fig. 4C may be used as an etching stopper.

As shown in Fig. 4N, a third resin layer 52 is provided on the lower face of the first resin layer 26-1. The third resin layer 52 can be formed in such a manner that a semi-cured resin sheet, a resin film or the like is attached to the first resin layer 26-1 and then heat-cured, or in such a manner that an pre-cured resin is applied to the first resin layer 26-1 by screen printing and then cured.

As shown in Fig. 40, openings 52a for forming third via-holes 42 are formed in such a manner that regions of the third resin layer 52 located below the copper layers 62 are irradiated with a laser beam. In this step, the copper layers 62 function as stoppers; hence, the openings 52a extend up to the lower faces of the copper layers 62. The openings 52a may broaden downward and may taper upward, that is, the openings 52a may have an upward tapered shape. As described above, the step shown in Fig. 40 is substantially identical to that shown in Fig. 2M except for the absence of the copper foils 23.

An electroless plating step performed as shown in Fig. 4P is substantially identical to the step shown in Fig. 2N. A plating resist-forming step performed as shown in Fig. 4Q is substantially identical to the step shown in Fig. 20. An electrolytic plating step performed as shown in Fig. 4R is substantially identical to the step shown in Fig. 2P. A plating resist-removing step performed as shown in Fig. 4S is substantially identical to the step shown in Fig. 2Q.

As shown in Fig. 4T, an electroless plating layer 37 is partly removed by quick etching such that portions of the electroless plating layer 37 remain in the third via-holes 42. In this step, etching resist layers may be used to cover the third via-holes 42.

According to the above procedure, the multilayer printed wiring board 30 shown in Fig. 3 can be manufactured.

### [Third Embodiment]

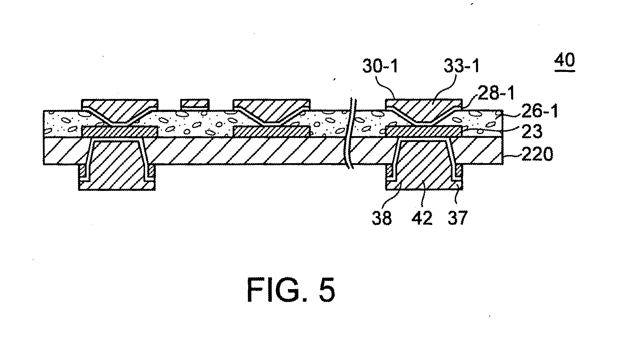

Referring to Figure 5, a multilayer printed wiring board 40 of the third embodiment has an insulating layer 220 having an opening. A conductive film 23 made of, for example Cu, Au, Ag, Ni, W, is formed on the upper surface of the insulating layer and is closing one end of the opening of the insulating layer. A resin layer 26-1 made of, for example, epoxy, polyimide, or a mixture made of thermosetting resin and thermoplastic resin is formed on the insulating layer 220 and the conductive film 23 and has an opening reaching to the conductive film 23. A via-hole structure 42 is formed in the opening of the insulating layer 220 and has an electroless plating film 37 and an electroplating film 38.

The electroless plating film 37 is formed on the surface of the opening of the insulating layer and the lower surface of the conductive film 23, and the electroplating film 38 is formed on the electroless plating film 37. Another via-hole structure 33-1 is formed in the opening of the insulating layer 26-1 and has an electroless plating film 28-1 and an electroplating film 30-1. The electroless plating film 28-1 is formed on the surface of the opening of the insulating layer and the upper surface of the conductive film, and the electroplating film 30-1 formed on the electroless plating film 28-1.

Thus, on the upper surface of the conductive film, one via-hole structure having an electroless plating film and an electroplating film in this order is formed, and on the lower surface of the conductive film, the other via-hole structure having an electroless plating film and an electroplating film in this order is formed. By providing such a structure, stress due to those plating films on the multilayered printed wiring board is reduced significantly.

The insulating layer 220 may be a core layer or a coreless layer. The core layer has a resin and a core material such as a glass cloth or a glass fiber, and the core layer may be a single-side or a double-side copper-clad laminate. For example the core layer may be made of a glass cloth base epoxy-resin impregnated copper-clad laminate, a glass-based material impregnated with a bismaleimide triazine resin, a laminate including a glass-based material impregnated with a polyphenylene ether resin, or a laminate including a glass-based material impregnated with a polyimide resin. The coreless layer has a resin layer without the core material. For example, the coreless layer may be made of a resin layer such as epoxy, polyimide without the core layer.

The multilayer printed wiring board 40 of the third embodiment may be manufactured by the steps shown in Figs. 4A to 4T without repeating the steps shown in Fig. 4E to 4K.

### [Others]

The embodiments describe above are for exemplification and should not in any way be construed as limitative. The present invention covers modifications, variations, and substitutes readily made by those skilled in the art.
(1) The manufacturing steps described above are current typical examples. Hence, materials, manufacturing conditions, and the like used in the manufacturing steps may be varied depending on various circumstances.
(2) In the embodiments described above, the semiconductor elements are mounted on the upper faces of the multilayer printed wiring boards. However, the present invention covers multilayer printed wiring boards including semiconductor elements mounted on the lower faces or both faces thereof.
(3) The multilayer printed wiring boards 20 and 30 shown in Fig. 1 or 3 each include the first and second resin layers 26-1 and 26-2. However, the number of resin layers included in a multilayer printed wiring board according to the present invention is not limited to two and may be three or more. Alternatively, such a multilayer printed wiring board may include a single resin layer.
(4) A method for manufacturing a multilayer printed wiring board according to the present invention may include a step of attaching two copper-clad laminates or support plates to each other with an adhesive such as wax and a step of removing the copper-clad laminates or the support plates, the removing step being subsequent to a step of forming portions such as via-holes and patterns for lands and/or conductive circuits in a resin layer. The adhesive is not melted or softened at a process temperature during manufacturing steps but is melted or softened at a temperature lower than a temperature at which the multilayer printed wiring board is deteriorated.

Specifically, in the method of the first embodiment, the steps shown in Figs. 2A to 2L may be applied to each of two copper-clad laminates 21 including copper foils 23 attached to each other such that the copper foils 23 are fixed to each other with an adhesive. In the method of the second embodiment as well as the method of the first embodiment, the steps shown in Figs. 4A to 4L may be applied to each of two support plates or copper plates 60 attached to each other with an adhesive. Then, two printed boards obtained are separated from each other and separately processed in subsequent steps.

According to this procedure, since the two copper-clad laminates 21 or support plates 60 are fixed to each other with such an adhesive, the two copper-clad laminates or support plates can be processed into the two printed boards simultaneously or successively, whereby two multilayer printed wiring boards can be manufactured at once. The two multilayer printed wiring boards fixed to each other are heated to a temperature at which the adhesive is melted or softened, whereby the two multilayer printed wiring boards are separated from each other. The resulting two multilayer printed wiring boards are then separately processed in subsequent steps.

The scope of the present invention is defined by the appended claims.

## Claims

1. A multilayer printed wiring board comprising:
one or more resin layers having via-holes; and
a core layer having via-holes,
wherein the via-holes of the one or more resin layers are open in the direction opposite to the direction in which the via-holes of the core layer are open.

2. The multilayer printed wiring board according to Claim 1,
wherein the multilayer printed wiring board has a surface for mounting a semiconductor element and a surface on which an external terminal is formed,
the via-holes formed in the one or more resin layers are open in the surface for mounting a semiconductor element, and
the via-holes formed in the core layer are open in the surface on which an external terminal is formed.

3. A multilayer printed wiring board comprising:
a first resin layer;
first via-holes formed in the first resin layer;
a second resin layer disposed on the upper face of the first resin layer;
second via-holes formed in the second resin layer;
a core layer disposed on the lower face of the first resin layer; and
via-holes formed in the core layer;
wherein the via-holes formed in the first and second resin layers are open in the direction opposite to the direction in which the via-holes formed in the core layer are open.

4. The multilayer printed wiring board according to Claim 1 or 3, wherein the via-holes are filled with a conductor.

5. The multilayer printed wiring board according to Claim 1 or 3,
wherein the via-holes formed in the one or more resin layers broaden upward and taper downward, and
the via-holes formed in the core layer taper upward and broaden downward.

6. The multilayer printed wiring board according to Claim 3, further comprising one or more resin layers, disposed on the upper face of the second resin layer, having via-holes.

7. The multilayer printed wiring board according to Claim 1 or 3, wherein the core layer is made of fiber-reinforced plastics.

8. The multilayer printed wiring board according to Claim 1 or 3, wherein the core layer includes a substrate prepared by impregnating a woven glass fabric or a nonwoven aramid fabric with an epoxy resin or a bismaleimide-triazine resin and then subjecting the resulting resin to curing.

9. The multilayer printed wiring board according to Claim 8, wherein the glass fabric has a two-ply construction.

10. The multilayer printed wiring board according to Claim 1 or 3, wherein the core layer is prepared from a single- or double-sided copper-clad laminate and has lands prepared of a copper foil attached to the laminate.

11. A method for manufacturing a multilayer printed wiring board, comprising:
a step of preparing a single- or double-sided copper-clad laminate;
a step of forming lands by processing the laminate;
a step of forming a resin layer on the upper face of the laminate, forming openings for via-holes in the resin layer, and then forming the via-holes; and
a step of forming openings for via-holes in the lower face of the laminate and then forming the via-holes,
wherein the via-holes formed in the resin layer are open in the direction in which the via-holes formed in the laminate are open.

12. The method according to Claim 11,
wherein the via-holes formed in the resin layer broaden upward and taper downward in cross section, and
the via-holes formed in the laminate taper upward and broaden downward in cross section.

13. The method according to Claim 11, wherein the laminate includes a glass fabric impregnated with an epoxy resin.

14. The method according to Claim 11, further comprising:
one or more steps of forming another resin layer, forming openings for via-holes, and then forming the via-holes, the one or more steps being subsequent to the step of forming the resin layer on the upper face of the laminate, forming the openings in the resin layer, and then forming the via-holes.

15. The method according to Claim 11, wherein the via-holes are filled with a conductor by plating process.

16. The method according to Claim 11, wherein the openings are formed with a laser.

17. The method according to Claim 11,
wherein two single- or double-sided copper-clad laminates including glass-based materials impregnated with an epoxy resin are prepared and then attached to each other with an adhesive in the laminate-preparing step;
the attached laminates are processed together in the land-forming step and the step of forming the resin layer on the upper face of the laminate, forming the openings in the resin layer, and then forming the via-holes;
the processed laminates are separated from each other by melting or softening the adhesive; and
the separated laminates are separately subjected to the step of forming the openings in the lower face of the laminate and then forming the via-holes.

18. A coreless multilayer printed wiring board comprising:
a first resin layer;
via-holes formed in the first resin layer;
a second resin layer disposed on the upper face of the first resin layer;
via-holes formed in the second resin layer;
a third resin layer disposed on the lower face of the first resin layer; and
via-holes formed in the third resin layer;
wherein the via-holes formed in the first and second resin layers are open in the direction opposite to the direction in which the via-holes formed in the third resin layer are open.

19. The multilayer printed wiring board according to Claim 18, wherein the via-holes formed in the first and second resin layers broaden upward and taper downward and the via-holes formed in the third resin layer taper upward and broaden downward.

20. The multilayer printed wiring board according to Claim 18, further comprising one or more resin layers similar to the first or second resin layer.

21. A method for manufacturing a multilayer printed wiring board, comprising the steps of:
preparing a support plate;
forming lands on the support plate;
forming a first resin layer on the upper face of the support plate, forming openings for via-holes in the first resin layer, and then forming the via-holes;
forming a second resin layer on the upper face of the first resin layer, forming openings for via-holes in the second resin layer, and then forming the via-holes;
removing the support plate; and
forming a third resin layer on the lower face of the first resin layer, forming openings for via-holes in the third resin layer, and then forming the via-holes;
wherein the via-holes formed in the first and second resin layers are open in the direction opposite to the direction in which the via-holes formed in the third resin layer are open.

22. The method according to Claim 21, wherein the support plate is made of copper.

23. The method according to Claim 21, wherein the via-holes formed in the first and second resin layers broaden upward and taper downward and the via-holes formed in the third resin layer taper upward and broaden downward.

24. The method according to Claim 21, further comprising two or more steps of forming another resin layer, forming openings for via-holes, and then forming the via-holes.

25. The method according to Claim 21, wherein the via-holes are filled with a conductor by plating process.

26. The method according to Claim 21, wherein the openings are formed with a laser.

27. The method according to Claim 21,
wherein two support plates are prepared and then attached to each other with an adhesive in the laminate-preparing step;
the attached support plates are processed together in the land-forming step and the second resin layer-forming step;
the processed support plates are separated from each other by melting or softening the adhesive; and the separated support plates are separately subjected to the support plate-removing step.
